# EUROPÄISCHE PATENTSCHRIFT

(11) **EP 2 678 547 B1**
(45) Veröffentlichungstag und Bekanntmachung des Hinweises auf die Patenterteilung: **17.05.2017**
(21) Anmeldenummer: 12705302.3
(22) Anmeldetag: 22.02.2012
(51) Int. Cl.: F02G 5/02, F28D 20/02, F01N 5/02

(54) **BETRIEB EINER BRENNKRAFTMASCHINE**
OPERATION OF AN INTERNAL COMBUSTION ENGINE
FONCTIONNEMENT D'UN MOTEUR À COMBUSTION INTERNE

(30) Priorität: 25.02.2011 DE 102011004794
(43) Veröffentlichungstag der Anmeldung: 01.01.2014
(73) Patentinhaber: Bombardier Transportation GmbH, 10785 Berlin (DE)
(72) Erfinder: GERADTS, Karlheinz, CH-5603 Staufen AG (CH); SONNLEITNER, Werner, 34292 Ahnatal (DE)
(74) Vertreter: Patentanwälte Bressel und Partner mbB
(86) Internationale Anmeldenummer: PCT/EP2012/053003
(87) Internationale Veröffentlichungsnummer: WO 2012/113824

(56) Entgegenhaltungen:
- DE-A1-102007 045 164
- DE-B3-102006 040 853
- FR-A1- 2 943 731
- JP-A- 2005 083 251

## Beschreibung

Die Erfindung betrifft eine Anordnung zur Nutzung von Abwärme einer Brennkraftmaschine in einem Fahrzeug, insbesondere in einem Schienenfahrzeug, wobei die Anordnung einen Abgasstrang zum Ableiten von Abgasen der Brennkraftmaschine aufweist und der Abgasstrang thermisch mit einer Hochtemperaturseite eines thermoelektrischen Generators gekoppelt ist. Die Erfindung betrifft ferner ein Verfahren zum Betreiben einer Brennkraftmaschine in einem Fahrzeug, insbesondere in einem Schienenfahrzeug, wobei Abgase der Brennkraftmaschine über einen Abgasstrang abgeleitet werden und mit den Abgasen abgeleitete Abwärme der Brennkraftmaschine einer Hochtemperaturseite eines thermoelektrischen Generators zugeführt wird und der thermoelektrische Generator unter Nutzung der Abwärme elektrische Energie erzeugt.

Eine solche Anordnung und ein derartiges Verfahren sind aus US 2005/0268955 A1 bekannt. Wie auch in dieser Druckschrift beschrieben kann die Brennkraftmaschine insbesondere der Antriebsmotor eines Fahrzeuges, z. B. eines Schienenfahrzeuges sein. Insbesondere erzeugt die Brennkraftmaschine in diesem Fall (insbesondere durch den Antrieb eines mechanisch angetriebenen elektrischen Generators) Energie für eine Traktion des Fahrzeuges und optional auch für andere Einrichtungen des Fahrzeugs. Die Brennkraftmaschine ist üblicherweise thermisch mit mindestens einem Kühlmittelkreislauf gekoppelt.

Die Erfindung betrifft insbesondere das Gebiet der Schienenfahrzeuge, bei denen typischerweise sehr viel leistungsstärkere Brennkraftmaschinen zum Einsatz kommen als bei Straßenkraftfahrzeugen. Bei dem Schienenfahrzeug kann es sich insbesondere um eine Lokomotive handeln, z.B. um eine dieselelektrisch angetriebene Lokomotive. Denkbar ist die Anwendung der Erfindung aber auch bei anderen Fahrzeugen, z.B. Schiffen.

Bei der Anordnung, die in US 2005/0268955 A1 beschrieben wird, treten starke Schwankungen bei der Erzeugung elektrischer Leistung durch den thermoelektrischen Generator auf. Insbesondere ist die elektrische Leistung des Generators gering, wenn die Brennkraftmaschine eine geringe mechanische Leistung erzeugt. Verschärft wird das Problem dadurch, dass auch der Wirkungsgrad, mit dem ein thermoelektrischer Generator aus Wärme elektrische Energie erzeugt, unter anderem vom Temperaturniveau auf der Hochtemperaturseite des Generators abhängt. Bei der Nutzung von Abwärme aus dem Abgasstrang der Brennkraftmaschine schwankt aber die Temperatur des Abgases erheblich innerhalb eines sehr großen Temperaturbereichs.

DE 10 2006 040 853 B3 beschreibt eine Einrichtung der Thermoelektrik mit einem thermoelektrischen Generator und Mitteln zur Temperaturbegrenzung an dem Generator. Auf einer ersten Seite ist der thermoelektrische Generator mit einer Wärmequelle verbunden. Auf einer zweiten Seite ist der thermoelektrische Generator mit einer Wärmesenke thermisch verbunden. Die Mittel zur Temperaturbegrenzung weisen eine sich gegenüberliegende Flächen aufweisende flache erste Kammer auf, die mit einem schmelzbaren ersten Arbeitsmedium ausgefüllt ist und die großflächig an ihren sich gegenüberliegenden Flächen thermisch mit der Wärmequelle bzw. dem thermoelektrischen Generator verbunden ist. Die Wärmequelle kann mit Teilen eines Abgassystems verbunden sein und die Wärmesenke mit Teilen des Kühlsystems einer Verbrennungsmaschine verbunden sein.

FR 2 943 731 A1 beschreibt eine Auspuffanlage für Kraftfahrzeuge mit geschlossenem Kreislauf zur Rückgewinnung von thermischer Energie aus Abgasen. Ein Wärmetauscher weist eine erste Seite zur Zirkulation der Abgase und eine zweite Seite zur Zirkulation eines Wärmetauschermediums auf. In einem geschlossenen Kreislauf zur Rückgewinnung eines Teils der thermischen Energie aus den Abgasen strömt das Wärmetauschermedium, wobei die zweite Seite des Wärmetauschers in den geschlossenen Kreislauf eingefügt ist. Der Wärmetauscher weist eine Zwischenwand auf, die zwischen die erste und die zweite Seite des Wärmetauschers eingefügt ist, wobei die Zwischenwand zumindest einen geschlossenen Hohlraum enthält, der ein Material zur Phasenumwandlung beinhaltet. Der geschlossene Kreislauf enthält z.B. eine Turbine, über die eine Antriebswelle drehend angetrieben wird, wobei die Antriebswelle beispielsweise mit einer Lichtmaschine verbunden ist.

Es ist eine Aufgabe der Erfindung, eine Anordnung zur Nutzung von Abwärme einer Brennkraftmaschine in einem Fahrzeug, insbesondere in einem Schienenfahrzeug, anzugeben, die es ermöglicht, die von dem thermoelektrischen Generator erzeugte elektrische Leistung zumindest bei Bedarf für elektrische Leistung konstanter zu halten. Ferner ist es eine Aufgabe der Erfindung, ein entsprechendes Verfahren zum Betreiben einer Brennkraftmaschine in einem Fahrzeug, insbesondere in einem Schienenfahrzeug, anzugeben.

Die beigefügten Patentansprüche definieren den Schutzumfang.

Gemäß einem Grundgedanken der vorliegenden Erfindung wird auch ein Latentwärmespeicher thermisch mit der Hochtemperaturseite des thermoelektrischen Generators gekoppelt. Für die Aufladung des Latentwärmespeichers gibt es verschiedene Möglichkeiten. In jedem Fall ist der Latentwärmespeicher aber in der Lage, der Hochtemperaturseite des thermoelektrischen Generators Wärme zuzuführen, um zumindest bei Bedarf eine elektrische Leistung zu erzeugen, die z.B. bei geringer mechanischer Leistung der Brennkraftmaschine und damit geringen Abgastemperaturen nicht durch Abwärme aus dem Abgasstrang erzeugt werden kann.

Gemäß der Erfindung werden zum Betreiben einer Brennkraftmaschine in einem Fahrzeug, insbesondere in einem Schienenfahrzeug,
- Abgase der Brennkraftmaschine über einen Abgasstrang abgeleitet,
- mit den Abgasen abgeleitete Abwärme der Brennkraftmaschine einer Hochtemperaturseite eines thermoelektrischen Generators zugeführt und erzeugt der thermoelektrische Generator unter Nutzung der Abwärme elektrische Energie,
- wird außerdem (gleichzeitig und/oder in anderen Zeiträumen) Wärme aus einem Latentwärmespeicher der Hochtemperaturseite des thermoelektrischen Generators zugeführt und erzeugt der thermoelektrische Generator unter Nutzung der Wärme elektrische Energie.

Vorzugsweise ist die Entladung des Latentwärmespeichers steuerbar bezüglich der Entladeleistung. Darauf wird noch näher eingegangen. In jedem Fall aber sind die Möglichkeiten der Bereitstellung einer elektrischen Leistung durch den thermoelektrischen Generator durch den Latentwärmespeicher verbessert. Daher können z.B. auch elektrische Einrichtungen an den thermoelektrischen Generator angeschlossen werden, die zumindest in bestimmten Betriebsphasen eines Fahrzeuges nicht ohne oder nicht mit wenig elektrischer Leistung betrieben werden können. Selbstverständlich kann die Verfügbarkeit elektrischer Leistung noch dadurch gesteigert werden, dass elektrische und/oder elektrochemische Energiespeicher eingesetzt werden.

Insbesondere kann sich innerhalb des Latentwärmespeichers zumindest ein elektrischer Heizwiderstand befinden, um den Latentwärmespeicher aufzuladen. Fließt ein elektrischer Strom durch den zumindest einen Heizwiderstand, erzeugt dieser Wärme, die den Latentwärmespeicher auflädt. Eine bevorzugte Quelle für den elektrischen Strom ist ein elektrischer Generator (insbesondere ein Traktionsmotor), der beim Bremsen des Fahrzeugs elektrische Energie erzeugt. Es könnte auch aus Abgas-Abwärme erzeugte elektrische Leistung des thermoelektrischen Generators zur Aufladung des Latentwärmespeichers genutzt werden. Dies ist jedoch im Vergleich zu anderen Verfahren weniger effektiv.

Gemäß den beigefügten Patentansprüchen wird der Latentwärmespeicher mittels einer elektrischen Speicherladeeinrichtung aufgeladen, die mit elektrischer Energie betrieben wird, welche beim Abbremsen des Fahrzeugs erzeugt wird. Es ist an sich bekannt, beim Abbremsen von Schienenfahrzeugen, die elektrischen Fahrmotoren als elektrische Generatoren zu betreiben und die so erzeugte elektrische Energie zum Aufladen eines elektrischen oder elektrochemischen Energiespeichers zu nutzen. Diese generatorische Betriebsweise der Fahrmotoren dient aber auch als so genannte dynamische Bremse und wird auch dann ausgeführt, wenn die elektrischen oder elektrochemischen Energiespeicher voll aufgeladen sind. In diesem Fall muss die elektrische Bremsenergie in üblichen, aus dem Stand der Technik bekannten Anordnungen über Heizwiderstände in Wärme umgewandelt werden und wird diese Wärme an die Umgebung abgegeben, so dass sie einer weiteren Nutzung in dem Fahrzeug nicht zur Verfügung steht. Eine auf diese Weise erzeugte Wärme wird daher vorteilhafterweise in den Latentwärmespeicher eingebracht. Dem liegt insbesondere der Gedanke zugrunde, dass ein Hochtemperatur-Latentwärmespeicher (hierauf wird noch näher eingegangen) bei geringem Bauvolumen eine sehr hohe Speicherkapazität aufweist. Betriebssituationen, in denen die Bremsenergie nicht mehr zum Aufladen des Latentwärmespeichers genutzt werden kann, sind daher selten.

Wenn in dieser Beschreibung Grundgedanken und Ausführungsformen der Erfindung unter Bezugnahme auf eine Brennkraftmaschine beschrieben werden, so gilt dies analog auch für eine Mehrzahl von Brennkraftmaschinen. Z.B. kann ein Fahrzeug mehrere Brennkraftmaschinen aufweisen und wird die Abwärme aus den Abgassträngen der Brennkraftmaschinen oder zumindest einer Mehrzahl der Brennkraftmaschinen in derselben Weise genutzt, wie es für eine Brennkraftmaschine beschrieben wird.

Bei dem thermoelektrischen Generator kann es sich insbesondere um einen Wärmetauscher mit integrierten thermoelektrischen Elementen handeln. Ein Wärmetransportfluid, das insbesondere in einem ersten Wärmetransportkreislauf zirkuliert, transportiert Wärme zu dem Wärmetauscher, der die Wärme an der Hochtemperaturseite der thermoelektrischen Elemente aufnimmt und an die Niedertemperaturseite der thermoelektrischen Elemente überträgt. Vorzugsweise handelt es sich bei dem Wärmetauscher mit integrierten thermoelektrischen Elementen um einen Plattenwärmetauscher.

Vorzugsweise ist der Abgasstrang über einen ersten Wärmetauscher der Anordnung (bei dem es sich nicht um den Wärmetauscher mit den thermoelektrischen Elementen handelt) thermisch mit einem ersten Wärmetransportkreislauf gekoppelt. Ein Vorlauf des ersten Wärmetransportkreislaufs führt von dem ersten Wärmetauscher zu der Hochtemperaturseite des thermoelektrischen Generators, um den Abgasstrang mit der Hochtemperaturseite zu koppeln. Dies hat gegenüber der in US 2005/0268955 A1 beschriebenen Ausführungsform, bei der unmittelbar die Abgase der Brennkraftmaschine Wärme zu der Hochtemperaturseite des thermoelektrischen Generators übertragen, den Vorteil, dass weitere Komponenten thermisch an den ersten Wärmetransportkreislauf angekoppelt werden können (insbesondere der Latentwärmespeicher oder ein Abgasrückführungskühler (AGR) der Brennkraftmaschine). Ferner ist mit einem speziellen Wärmetransportfluid ein besserer Wärmeübergang auf den thermoelektrischen Generator möglich. Dies ist besonders wichtig für eine effektive Erzeugung elektrischer Energie des zumindest einen thermoelektrischen Elements des thermoelektrischen Generators. Insbesondere kann zwar der Wärmetauscher, mit dem die Abwärme vom Abgas auf das Wärmetransportfluid übertragen wird, sehr effektiv gestaltet werden (z.B. als koaxialer Wärmetauscher, Rohrbündel-, Platten- oder als Blockwärmetauscher), thermoelektrische Elemente lassen sich jedoch nicht in derselben effizienten Weise bezüglich der Erzeugung elektrischer Energie in einen solchen Gas-Fluidwärmetauscher integrieren, wie es bei einem Fluid-Wärmetauscher der Fall ist. Insbesondere kann der thermoelektrische Generator, wie bereits oben erwähnt, ein Plattenwärmetauscher sein. Allgemeiner formuliert kann es sich bei dem thermoelektrischen Generator um einen Fluid-Fluidwärmetauscher handeln, wobei vorzugsweise zumindest das Fluid auf der Hochtemperaturseite eine Flüssigkeit ist, insbesondere ein Öl. Ebenfalls wird jedoch bevorzugt, dass auch das Fluid auf der Niedertemperaturseite eine Flüssigkeit ist. In diesem Fall existiert also auch auf der Niedertemperaturseite des thermoelektrischen Generators ein zweiter Wärmetransportkreislauf, mit dem die von der Hochtemperaturseite auf die Niedertemperaturseite übertragene Wärme abtransportiert wird und z.B. über einen Fluid-Luftwärmetauscher auf die Umgebung übertragen wird.

Falls ein Ausgleichsbehälter, der auch als Expansionstank bezeichnet werden kann, vorhanden ist, gleicht dieser vorzugsweise auch Volumenschwankungen im ersten Wärmetransportkreislauf aus. Dazu kann der Ausgleichsbehälter außer dem Fluid (insbesondere dem Öl) auch unter Druck stehendes Gas (vorzugsweise Inertgas) enthalten. Im Fall eines Öls verhindert Inertgas (z.B. Stickstoff), dass das Öl oxidiert. Ferner kann an den Ausgleichsbehälter ein Überdruckventil angeschlossen sein, das im Fall des Überschreitens eines vorgegebenen Überdruckes Öl aus dem Ausgleichsbehälter entlässt. Alternativ oder zusätzlich kann der Druck des Gases in dem Ausgleichsbehälter mit Hilfe eines steuerbaren Ventils und einem unter höheren Druck stehenden Gasvorrat gesteuert werden. Auch für das Gas kann ein weiteres Ventil vorhanden sein, um Gasdruck abzubauen.

Wie erwähnt, kann die von dem thermoelektrischen Generator erzeugte elektrische Energie für den Betrieb zumindest eines elektrischen Verbrauchers des Fahrzeugs genutzt werden. Dementsprechend ist der thermoelektrische Generator mit zumindest einem elektrischen Verbraucher des Fahrzeugs verbunden. Die elektrische Energie wird diesem zumindest einen elektrischen Verbraucher insbesondere bei Bedarf zugeführt. Dabei kann der thermoelektrische Generator direkt (d.h. über eine elektrische Leitung, ohne Zwischenschaltung von Einrichtungen zur Umwandlung der Energie bezüglich Strom unter Spannung) mit dem zumindest einen elektrischen Verbraucher verbunden sein. Dies wird jedoch nicht bevorzugt. Vielmehr wird bevorzugt, dass der von dem thermoelektrischen Generator erzeugte Gleichstrom einem Spannungswandler zugeführt wird, der auch als Konverter bezeichnet werden kann. Bei dem Konverter kann es sich um einen DC/DC-Konverter handeln, d.h. um einen Gleichspannungswandler. Es kann sich bei dem Konverter aber auch um einen DC/AC-Konverter handeln, der einen Gleichstrom auf der Seite des thermoelektrischen Generators in einen Wechselstrom für den Betrieb von elektrischen Einrichtungen in dem Fahrzeug umwandelt. Dieser Wechselstrom kann direkt für die Versorgung eines elektrischen Verbrauchers genutzt werden und/oder über einen Gleichrichter in den Gleichspannungszwischenkreis eingespeist werden. Die Seite des Konverters, auf der sich hinsichtlich der elektrischen Verschaltung der thermoelektrische Generator befindet, kann als Primärseite bezeichnet werden. Die andere Seite des Konverters ist dann die Sekundärseite. Auf der Sekundärseite kann der Konverter z.B. mit einem Gleichspannungszwischenkreis des Fahrzeugs verbunden sein, der bei Lokomotiven und anderen Schienen-Triebfahrzeugen typischerweise vorhanden ist. In den Gleichspannungszwischenkreis wird üblicherweise Energie aus einer Energiequelle eingespeist, die insbesondere der Traktion des Fahrzeugs dient, d.h. elektrische Fahrmotoren mit Energie versorgt. Im bevorzugten Fall eines dieselelektrischen Aggregats als Antriebseinrichtung des Fahrzeugs, die eine Dieselmaschine als Brennkraftmaschine aufweist, deren Abwärme erfindungsgemäß wie oben beschrieben genutzt wird, und ferner einen elektrischen Generator aufweist, der von der Dieselmaschine mechanisch angetrieben wird und einen Wechselstrom erzeugt, wird der Wechselstrom des Generators gleichgerichtet und in den Gleichspannungszwischenkreis eingespeist. Für den Antrieb zumindest eines Fahrmotors wird elektrische Gleichspannungsenergie aus dem Gleichspannungszwischenkreis entnommen und über einen Wechselrichter in Wechselstromenergie umgewandelt. Auch Hilfsbetriebe des Fahrzeugs, die nicht unmittelbar der Traktion dienen, können über einen zusätzlichen Wechselrichter mit dem Gleichspannungszwischenkreis verbunden sein.

Bei dem Konverter kann es sich insbesondere um einen oder mehrere MPPT (Maximum Power Point Tracking) Konverter für die Konvertierung des primärseitigen Eingangsstroms bzw. der Eingangsspannung in eine sekundärseitige Ausgangsspannung bzw. einen Ausgangsstrom handeln. Solche MPPT-Konverter sind handelsüblich und für sich genommen für die Verwendung in Schienenfahrzeugen bekannt. Vorzugsweise ist der Latentwärmespeicher über einen zweiten Wärmetauscher (der nicht Teil des thermoelektrischen Generators ist) an den ersten Wärmetransportkreislauf angeschlossen. Dazu führt vorzugsweise der Vorlauf des ersten Wärmetransportkreislaufs über den zweiten Wärmetauscher zu der Hochtemperaturseite des thermoelektrischen Generators, so dass der zweite Wärmetauscher den Vorlauf thermisch mit dem Latentwärmespeicher koppelt.

Dies ermöglicht es, den Latentwärmespeicher über den zweiten Wärmetauscher zu entladen und die entladene Wärme der Hochtemperaturseite des thermoelektrischen Generators zuzuführen. Damit kann eine noch konstantere und sich über größere Zeiträume erstreckende Versorgung der Hochtemperaturseite des thermoelektrischen Generators mit Wärme erreicht werden.

Vorzugsweise ist eine Steuereinrichtung der Anordnung vorgesehen und ausgestaltet, eine Entladung des Latentwärmespeichers über einen Wärmetauscher, insbesondere den zuvor genannten zweiten Wärmetauscher, zu bewirken. Die durch die Entladung entnommene Wärme aus dem Latentwärmespeicher wird der Hochtemperaturseite des thermoelektrischen Generators zugeführt.

Wie noch näher beschrieben wird, werden zur Steuerung einer Entladung des Latentwärmespeichers vorzugsweise ein Behälter des Latentwärmespeichers und ein Wärmetauscher, über den Wärme aus dem Latentwärmespeicher entnehmbar ist, relativ zueinander bewegt. Der Wärmeübergang von einem Latentwärmespeichermedium des Latentwärmespeichers auf ein Wärmetransportmedium eines Wärmetransportkreislaufs, insbesondere des ersten Wärmetransportkreislaufs, hängt von der relativen Position des Latentwärmespeichermediums und des Wärmetauschers ab. Somit ist es möglich, den Wärmeübergang zu erhöhen oder zu erniedrigen und insbesondere ist es auch möglich, einen Wärmeübergang von dem Latentwärmespeichermedium auf das Wärmetransportmedium nahezu zu unterbinden. In diesem Zustand verliert der Latentwärmespeicher lediglich deshalb Wärme, weil auch die beste Wärmedämmung einen Wärmeverlust nicht verhindern kann. Allerdings kann bei einem Latentwärmespeicher ein solcher Wärmeverlust relativ zu der Wärmespeicherkapazität und auch relativ zu der Wärmeübertragungsrate bei Entnahme von Wärme sehr gering sein.

Wie bereits oben erwähnt, kann die von der Hochtemperaturseite zu der Niedertemperaturseite des thermoelektrischen Generators übertragene Wärme von einem zweiten Wärmetransportkreislauf abtransportiert werden, der an die Niedertemperaturseite des thermoelektrischen Generators angekoppelt ist. Der zweite Wärmetransportkreislauf transportiert während des Betriebes des thermoelektrischen Generators Wärme zu einer Wärmesenke, z.B. der Umgebungsluft.

Zur Vermeidung eines Kaltstarts einer Brennkraftmaschine ist es üblich, die Maschine über den Kühlmittelkreislauf der Maschine vorzuwärmen. Hierzu werden Vorwärmgeräte verwendet, die meist durch Verbrennung des gleichen Kraftstoffes, der auch beim Betrieb der Brennkraftmaschine verbrannt wird, Wärme erzeugen und das Kühlmittel in dem Kühlmittelkreislauf erwärmen. Durch Zirkulation des erwärmten Kühlmittels gelangt die Wärme zu der Brennkraftmaschine. Die Verwendung von Vorwärmgeräten führt zu einem zusätzlichen Verbrauch von Treibstoff und zusätzlichen Abgas-Emissionen.

Eine weitere Möglichkeit der Vorwärmung des Kühlmittels besteht in der Verwendung von Latentwärmespeichern. Z.B. ist es bei Straßenkraftfahrzeugen bekannt, einen Parafin- oder Salzlösungsspeicher einzusetzen. Das Latentwärmespeichermedium Parafin befindet sich in dem voll aufgeladenen Zustand des Speichers auf einem Temperaturniveau von ca. 100°C.

Derartige Latentwärmespeicher benötigen ein großes Bauvolumen, um die für die Vorwärmung benötigte Wärme zu speichern. Auch das Gewicht solcher Speicher ist erheblich. Ein weiterer Nachteil besteht darin, dass sich die Speicher nur langsam entladen lassen, d.h. der Prozess des Vorwärmens nimmt erhebliche Zeit in Anspruch. Insbesondere das Latentwärmespeichermedium Parafin besitzt eine geringe Wärmeleitfähigkeit. Leistungsstarke Brennkraftmaschinen lassen sich daher in vertretbarer Zeit und bei vertretbarem Bauvolumen und Gewicht nicht mit den bekannten Latentwärmespeichern erwärmen.

Vorzugsweise ist der zweite Wärmetransportkreislauf über einen dritten Wärmetauscher thermisch mit einem Kühlmittelkreislauf der Brennkraftmaschine gekoppelt. Dies ermöglicht es, Wärme aus dem Latentwärmespeicher der Hochtemperaturseite des thermoelektrischen Generators zuzuführen, von der Hochtemperaturseite zu der Niedertemperaturseite zu übertragen (wobei vorzugsweise kein oder nur ein geringer elektrischer Strom von dem thermoelektrischen Generator genutzt wird) und die Wärme über den zweiten Wärmetransportkreislauf und den dritten Wärmetauscher dem Kühlmittelkreislauf der Brennkraftmaschine zuzuführen. Somit kann die Brennkraftmaschine nach einer Betriebspause oder beim ersten Start vorgewärmt werden.

Der zweite Wärmetransportkreislauf und der dritte Wärmetauscher können jedoch auch noch für einen weiteren Zweck oder alternativ nur für einen Zweck, d.h. nicht zur Vorwärmung der Brennkraftmaschine, genutzt werden. Dazu wird ein üblicherweise im Kühlmittelkreislauf vorhandener Wärmetauscher zur Abführung von Wärme an eine Wärmesenke (z.B. die Umgebungsluft) genutzt, und zwar zusätzlich zu einem Wärmetauscher in dem zweiten Wärmetransportkreislauf. Dies bedeutet, dass die von der Niedertemperaturseite des thermoelektrischen Generators abzuführende Wärme insbesondere in bestimmten Betriebssituationen besser einer Wärmesenke oder verschiedenen Wärmesenken zugeführt werden kann. Beim Betrieb eines Schienenfahrzeugs sind solche Betriebssituationen insbesondere dann anzutreffen, wenn die Außentemperatur, d.h. die Lufttemperatur der Umgebungsluft, an die die Wärme abzugeben ist, sehr hoch ist und/oder wenn das Schienenfahrzeug still steht oder nur mit geringer Geschwindigkeit fährt und dennoch die Brennkraftmaschine mit verhältnismäßig hoher mechanischer Leistung betrieben wird.

Um den Wärmeübergang vom zweiten Wärmetransportkreislauf über den dritten Wärmetauscher auf den Kühlmittelkreislauf steuern zu können, kann ein Bypass parallel zu dem dritten Wärmetauscher vorhanden sein, so dass das Wärmetransportmedium des zweiten Wärmetransportkreislaufes an dem dritten Wärmetauscher vorbeiströmen kann. Es ist z. B. mindestens ein Ventil vorgesehen, das es erlaubt zu steuern, ob das Wärmetransportmedium durch den Bypass und/oder durch den dritten Wärmetauscher strömt.

Zuvor und im Folgenden werden sowohl Grundgedanken und Ausgestaltungen einer erfindungsgemäßen Anordnung als auch eines erfindungsgemäßen Verfahrens beschrieben. Dabei gilt, dass sich aus der Beschreibung der Anordnung eine entsprechende Verfahrensweise ergibt und umgekehrt. Bevorzugte Ausgestaltungen des Verfahrens, soweit nicht wortwörtlich bereits beschrieben, ergeben sich auch aus den beigefügten Patentansprüchen.

Vorzugsweise wird ein Latentwärmespeichermedium verwendet, das eine möglichst hohe Phasenübergangstemperatur aufweist, welche über der maximal zulässigen Kühlmitteltemperatur eines Kühlmittelkreislaufes der Brennkraftmaschine liegt. Dabei wird bevorzugt, dass die Phasenübergangstemperatur mindestens 100 K über der maximal zulässigen Kühlmitteltemperatur liegt, d. h. deutlich darüber. Z.B. beträgt die maximal zulässige Kühlmitteltemperatur bei Wasser 100°C und bei Öl 300°C. Je nach Kühlmittel wird daher ein Latentwärmespeichermedium gewählt, das eine Phasenübergangstemperatur von mehr als 200°C oder mehr als 400°C hat. Alternativ oder zusätzlich wird bei der Auswahl des Speichermediums und damit der Phasenübergangstemperatur die Abgastemperatur der Brennkraftmaschine berücksichtigt. Vorzugsweise wird eine Phasenübergangstemperatur gewählt, die über der Abgastemperatur bei Volllastbetrieb der Brennkraftmaschine liegt.

Besonders bevorzugt wird Aluminium als Latentwärmespeichermedium, das bei normalem Umgebungsdruck für den Phasenübergang von fest auf flüssig eine Phasenübergangstemperatur von ca. 660°C hat. Aluminium ist als Speichermedium gut geeignet, da es vor allem in flüssigem Zustand, aber auch in festem Zustand sehr gut Wärme leitet. Dies gilt in etwas geringerem Maße auch für andere Metalle, die alternativ zu Aluminium oder zusätzlich als Latentwärmespeichermedium zum Einsatz kommen können. Die hohe Wärmeleitfähigkeit von Metallen ermöglicht eine besonders schnelle Aufladung und besonders schnelle Entladung des Speichers. Auch ist die Temperatur des Speichermediums innerhalb des Speichers sehr homogen, d.h. es treten nur sehr geringe Temperaturunterschiede in dem Speicher auf.

Ferner wird es bevorzugt, dass der Wärmeübergang von dem Speichermedium eines Latentwärmespeichers auf das Kühlmittel in dem Kühlmittelkreislauf steuerbar ist. Bei in gleicher Weise aufgeladenem Latentwärmespeicher bedeutet ein besserer Wärmeübergang einen höheren Wärmestrom und umgekehrt. Die Steuerbarkeit des Wärmeübergangs ermöglicht den Einsatz anderer Latentwärmespeichermedien, insbesondere von solchen Materialien, die einen speicherrelevanten Phasenübergang (z.B. von fest nach flüssig) bei höheren Temperaturen aufweisen, als es bei bisherigen Speichern, z.B. bei Parafinspeichern, bekannt ist. Die Steuerbarkeit des Wärmeübergangs hat jedoch auch bei Latentwärmespeichern mit an sich bereits bekannten Speichermedien den Vorteil, dass höhere Wärmeströme möglich sind, wenn der Speicher entsprechend konstruiert ist, z.B. eine größere Fläche aufweist, durch die hindurch der Wärmeübergang stattfindet. Durch die Steuerung des Wärmeübergangs kann die auf das Kühlmittel übergehende Wärme reduziert werden, wenn keine Vorwärmung benötigt wird. Im Fall gleicher Temperaturverhältnisse bei unterschiedlichem Wärmeübergang entspricht der Wärmeübergang der pro Zeiteinheit übertragenen Wärme, d.h. der Wärmeleistung. Da aber bei unterschiedlichen Latentwärmespeichern mit unterschiedlichen Speichermedien in der Regel verschiedene Temperaturverhältnisse herrschen, entspricht der Wärmeübergang im Sinne dieser Beschreibung einem effektiven Gesamt- Wärmeübergangskoeffizienten der an dem Wärmeübergang beteiligten Materialien.

Insbesondere wird zur Steuerung des Wärmeübergangs vorgeschlagen, dass ein Behälter des Latentwärmespeichers, der das latente Wärmespeichermedium enthält, relativ zu dem Kühlmittelkreislauf bewegt wird, so dass sich aufgrund verschiedener Relativpositionen des Behälters und des Kühlmittelkreislaufes die Wärmeübergangsfläche und damit auch der Wärmeübergang ändert. Unter der Wärmeübergangsfläche wird eine Fläche quer zur Strömungsrichtung der Wärme verstanden, durch die ein Wärmeübergang von dem Wärmespeichermedium auf das Kühlmittel stattfindet. Durch die Bewegung des Behälters und des Kühlmittelkreislaufes relativ zueinander wird die Größe dieser Wärmeübergangsfläche verändert. Falls, wie es bei einer bevorzugten Ausführungsform der Fall ist, im Bereich der Außenoberfläche des Speichers Materialien unterschiedlicher Wärmeleitfähigkeit vorhanden sind, nämlich gut wärmeisolierende Materialien und gut wärmeleitfähige Materialien, wird lediglich der auf die gut wärmeleitfähigen Materialien entfallende Anteil der Außenoberfläche als Wärmeübergangsfläche bezeichnet. Ein geringer Teil Wärme wird auch durch die gut wärmeisolierenden Materialien auf das Kühlmittel übertragen. Dieser Teil ist jedoch vernachlässigbar klein.

Zur Einstellung der Wärmeübergangsfläche kann der Behälter bewegt werden. Es ist jedoch alternativ oder zusätzlich auch möglich, einen Teil des Kühlmittelkreislaufs und/oder einen Wärmetauscher oder Teil eines Wärmetauschers zur Übertragung der Wärme von dem Latentwärmespeichermedium auf das Kühlmittel zu bewegen. Im Fall, dass zumindest auch ein wärmeisolierendes Material zwischen Kühlmittelkreislauf und Latentwärmespeichermedium bewegt wird, kann dieses Material als Teil des Wärmetauschers betrachtet werden. Befindet sich das wärmeisolierende Material in einer Position, in der es den Wärmeübergang behindert, weist der Wärmetauscher eine schlechte Wärmeleitfähigkeit auf. Insbesondere durch graduelles Entfernen des wärmeisolierenden Materials wird die Wärmeleitfähigkeit verbessert, so dass eine Vorwärmung des Kühlmittels stattfinden kann.

Bevorzugt wird jedoch, dass der Behälter bewegt wird, der das Latentwärmespeichermedium enthält, um die Wärmeübergangsfläche einzustellen.

Ausführungsbeispiele der Erfindung werden nun unter Bezugnahme auf die beigefügte Zeichnung beschrieben. Die einzelnen Figuren der Zeichnung zeigen schematisch:
- Fig. 1: eine erste Ausführungsform der Erfindung mit einer Brennkraftmaschine, ,
- Fig. 2: eine zweite Ausführungsform der Erfindung mit mehreren Brennkraftmaschinen und
- Fig. 3: einen Latentwärmespeicher und einen Wärmetauscher zur Entladung des Latentwärmespeichers

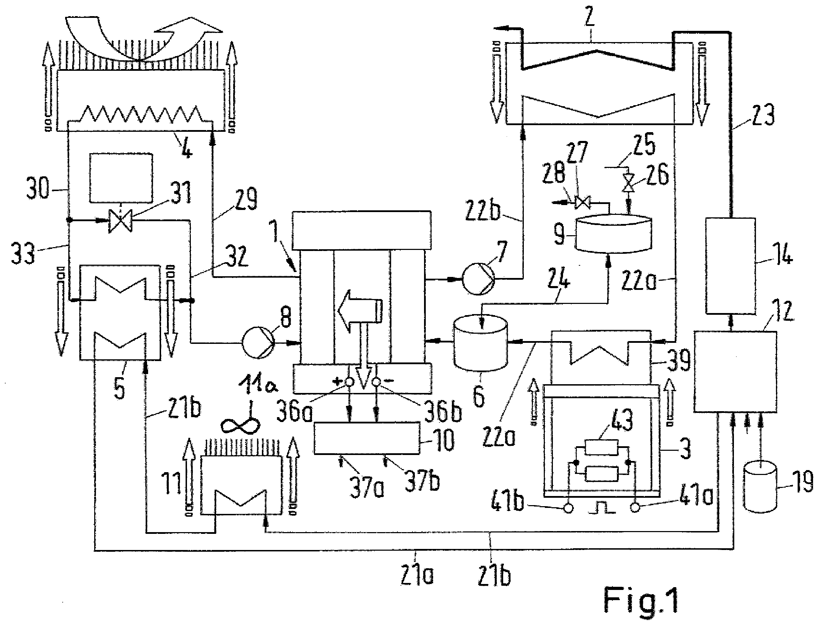

Figur 1 zeigt verschiedene Komponenten eines Systems zur Nutzung von Abwärme beim Betrieb einer Brennkraftmaschine 12, wobei die Brennkraftmaschine 12 insbesondere eine Maschine ist, die Energie für die Traktion des Fahrzeugs liefert. Mit der Brennkraftmaschine 12 ist eine Einrichtung 14 zur Nachbehandlung von Abgasen der Brennkraftmaschine 12 verbunden. Bei der Einrichtung 14 kann es sich um eine oder mehrere der folgenden Einrichtungen handeln: Eine Abgasrückführungseinrichtung (AGR), ein Dieselpartikelfilter, ein Oxidationskatalysator oder eine andere Katalysatoreinrichtung, insbesondere eine SCR (selective catalytic reduction)-Einrichtung.

Die Einrichtung 14 zur Abgasnachbehandlung ist ausgangsseitig über einen Abgasstrang 23, der durch eine Hochtemperaturseite eines ersten Wärmetauschers 2 führt, mit einem in Figur 1 nicht näher dargestellten Auspuff verbunden.

Auf einer Niedertemperaturseite des ersten Wärmetauschers 2 zirkuliert ein Wärmefluid, vorzugsweise ein Öl durch einen ersten Wärmetransportkreislauf 22, mit Vorlauf 22a und Rücklauf 22b. Der Vorlauf 22a führt von dem ersten Wärmetauscher 2 über einen zweiten Wärmetauscher 39 und über einen Ölspeicher 6 zu der Hochtemperaturseite eines thermoelektrischen Generators 1. Der Rücklauf 22b führt von der Hochtemperaturseite des thermoelektrischen Generators 1 über eine Umwälzpumpe 7 zum Umwälzen des Wärmefluids durch den ersten Wärmetransportkreislauf 22 zurück zu der Niedertemperaturseite des ersten Wärmetauschers 2.

Über den zweiten Wärmetauscher 39 nimmt das Wärmefluid gegebenenfalls Wärme von einem Latentwärmespeicher 3 auf. Es ist auch denkbar, dass über den zweiten Wärmetauscher 39 der Latentwärmespeicher 3 aufgeladen wird. Dies wird jedoch im normalen Betrieb des Fahrzeugs nicht bevorzugt oder allenfalls in Betriebssituationen, in denen der Latentwärmespeicher 3 vollständig oder nahezu vollständig entladen ist. Bevorzugt wird vielmehr, dass sich innerhalb des Latentwärmespeichers 3 eine Einrichtung 43 zum elektrischen Aufladen des Latentwärmespeichers 3 befindet. Elektrischer Strom fließt z. B. durch elektrische Heizwiderstände der Einrichtung 43, welche über elektrische Anschlüsse 41 a, 41 b an eine elektrische Anschlussleitung angeschlossen sind. Bevorzugt wird ferner, dass die Einrichtung 43 mit elektrischem Strom betrieben wird, der beim Abbremsen des Fahrzeugs im generatorischen Betrieb eines elektrischen Traktionsmotors erzeugt wird. Dieser zumindest eine elektrische Traktionsmotor wird in der bevorzugten Ausgestaltung von einem weiteren elektrischen Generator (z. B. dem Generator einer dieselelektrischen Antriebsvorrichtung einer Lokomotive) mit elektrischer Energie versorgt, wenn eine Traktion stattfindet. Dieser Generator wiederum wird von der Brennkraftmaschine 12 angetrieben. Alternativ oder zusätzlich zu der Nutzung von Bremsenergie kann auch andere elektrische Energie zum Betreiben der Einrichtung 43 genutzt werden.

Der Ölspeicher 6 ist über eine Leitung 24 mit einem Ausgleichsbehälter 9 verbunden. In spezieller Ausgestaltung steht ein Teilbereich des Volumens des Ausgleichsbehälters 9 unter dem Druck eines Inertgases, das über ein Ventil 26 und einen Gasanschluss 25 zugeführt oder auch abgelassen werden kann. Ferner ist das Ölvolumen des Ausgleichsbehälters 9 über ein Ventil 27 mit einem Auslass 28 verbunden, insbesondere um in besonderen Betriebssituationen Öl aus dem Ausgleichsbehälter 9 ablassen zu können. Diese Anordnung gewährleistet einen gleichmäßigen Öldruck innerhalb des ersten Wärmetransportkreislaufs 22.

Die Pumpe 7 kann auch an anderer Stelle des Wärmetransportkreislaufs 22 vorgesehen sein. Ferner können weitere Pumpen vorgesehen sein oder es kann, wenn auch nicht bevorzugt, auf Pumpen innerhalb des Kreislaufs 22 verzichtet werden, wenn die Zirkulation des Wärmetransportfluids durch dichte Unterschiede aufgrund unterschiedlicher Temperaturen möglich ist.

Wie durch einen breiten Pfeil, der von rechts nach links weist, angedeutet ist, fließt beim Betrieb der Anordnung Wärme von der Hochtemperaturseite des thermoelektrischen Generators 1 zu dessen Niedertemperaturseite. Dabei entsteht elektrische Energie, die über elektrische Anschlüsse 36a (mit Pluszeichen gekennzeichnet) und 36b (mit Minuszeichen gekennzeichnet) zu einem DC/AC auf Gleichstrom-Wechselstrom Stromrichter 10 abgeleitet wird und an entsprechenden Wechselstrom-Anschlüssen 37a, 37b des Stromrichters 10 zur weiteren Nutzung zur Verfügung steht.

Die Niedertemperaturseite des thermoelektrischen Generators 1 ist an einen zweiten Wärmetransportkreislauf 29, 30 angeschlossen. In diesem zweiten Wärmetransportkreislauf 29, 30 zirkuliert ein Wärmetransportfluid, insbesondere angetrieben durch eine Pumpe 8, nahe der Niedertemperaturseite des thermoelektrischen Generators 1. Über den Zweig 29 des zweiten Wärmetransportkreislaufs 29, 30 gelangt das Wärmetransportfluid zu der Hochtemperaturseite eines Fluid-Luftwärmetauschers 4, der die von dem thermoelektrischen Generator 1 abtransportierte Wärme zumindest teilweise an die Umgebungsluft überträgt. Die Rückführung des Wärmetransportfluids ist über zwei verschiedene Abschnitte des Kreislaufs 29, 30 möglich. An einer Verzweigung im Rücklauf 30 beginnt ein Abschnitt 32 des Kreislaufs, der über ein Beipassventil 31 und über die Pumpe 8 wieder zu der Niedertemperaturseite des Generators 1 führt. Ferner beginnt an der Verzweigung ein Abschnitt 33, der über eine Hochtemperaturseite eines dritten Wärmetauschers 5 ebenfalls über die Pumpe 8 zu der Niedertemperaturseite des Generators 1 führt. Durch Steuerung des Ventils 31 (durch ein Rechteck über dem Ventil 31 ist in Figur 1 die Steuerung schematisch dargestellt) kann der Durchfluss durch die Hochtemperaturseite des dritten Wärmetauschers 5 gesteuert werden. Bei vollständiger Öffnung des Beipassventils 31 fließt nur sehr wenig oder gar kein Wärmetransportfluid durch die Hochtemperaturseite des Wärmetauschers 5, da der Strömungswiderstand in dem Wärmetauscher 5 größer ist als in dem Abschnitt, der durch das Beipassventil 31 führt.

Die Niedertemperaturseite des Wärmetauschers 5 ist Teil eines Kühlkreislaufs 21 der Brennkraftmaschine 12 .Der Vorlauf 21 a des Kühlkreislaufs 21 führt zu der Brennkraftmaschine 12, um beim Betrieb des Kühlkreislaufs 21 diese zu kühlen. Der Rücklauf 21 b führt von der Brennkraftmaschine 12 über einen vierten Wärmetauscher 11, der ebenfalls wie auch der Wärmetauscher 4 ein Fluid-Luftwärmetauscher ist, zu der Niedertemperaturseite des dritten Wärmetauschers 5. Beim Betrieb des dritten Wärmetauschers 5 überträgt dieser Wärme von dem zweiten Wärmetransportkreislauf 29, 30 auf das Wärmetransportfluid in dem Kühlmittelkreislauf 21, um die Brennkraftmaschine 12 vorzuwärmen. Während des normalen Kühlbetriebes, insbesondere wenn die Brennkraftmaschine ihre normale Betriebstemperatur erreicht hat, zirkuliert ebenfalls Wärmetransportfluid in dem Kühlkreislauf 21, jedoch ist der dritte Wärmetauscher 5 nicht in Betrieb. Über den Fluid-Luftwärmetauscher 11 in dem Rücklauf 21 b des Kühlkreislaufs 21 wird dann Abwärme der Brennkraftmaschine 12 an die Umgebungsluft abgeführt.

Außerdem zeigt Figur 1 noch einen Kraftstofftank 19, insbesondere einen Dieselkraftstoff-Tank, wenn es sich bei der Brennkraftmaschine 12 um einen Dieselmotor handelt.

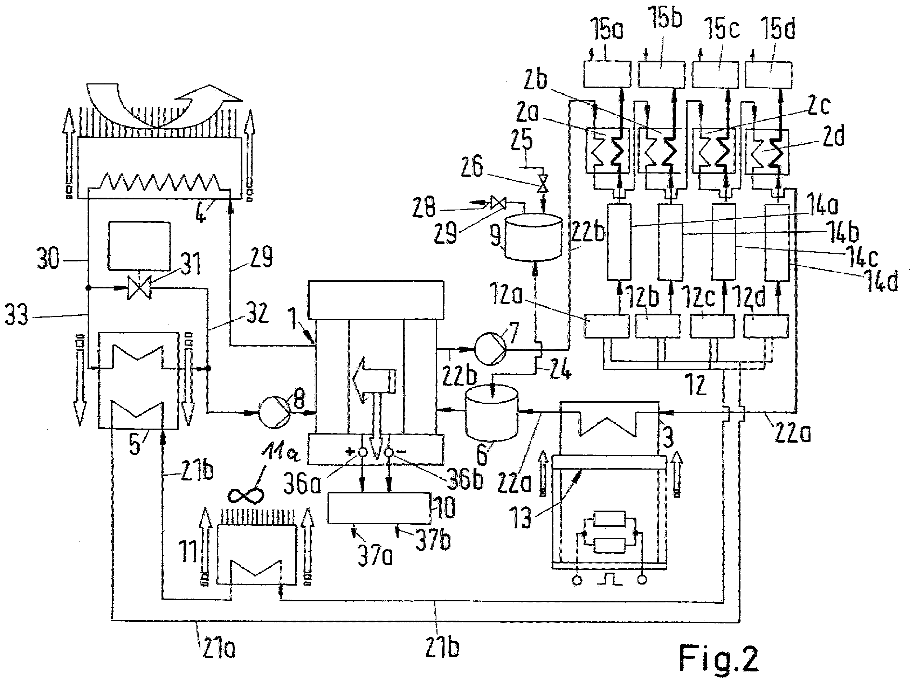

Figur 2 zeigt eine Variante der in Figur 1 dargestellten Anordnung. Im Folgenden werden lediglich die Unterschiede erläutert. Alle anderen Komponenten und Einrichtungen der Anordnung gleichen den in Figur 1 dargestellten Komponenten und Einrichtungen und werden insbesondere auf die gleiche Weise betrieben.

In Figur 2 ist kein Kraftstofftank dargestellt, obwohl zumindest ein solcher Tank vorhanden ist. Es sind vier Brennkraftmaschinen 12a, 12b, 12c, 12d dargestellt, die pauschal auch mit dem Bezugszeichen 12 als Antriebsaggregat bezeichnet sind. Jede dieser Brennkraftmaschinen 12 ist über eine Einrichtung 14a, 14b, 14c, 14d zur Abgasnachbehandlung mit einem Abgasstrang verbunden, der jeweils über einen ersten Wärmetauscher 2a, 2b, 2c, 2d zu einem Schalldämpfer 15a, 15b, 15c, 15d führt, über dem das jeweilige Abgas in die Umgebung eingeleitet wird. Die Abgasnachbehandlungseinrichtungen 14a bis 14d können in gleicher Weise konzipiert sein und funktionieren wie Einrichtung 14 aus Figur 1.

Die ersten Wärmetauscher 2a bis 2d werden seriell von einem Wärmetransportfluid durchströmt, das durch den ersten Wärmetransportkreislauf 22a, 22b zirkuliert. Dieser Wärmetransportkreislauf 22 unterscheidet sich von dem in Figur 1 dargestellten lediglich dadurch, dass die Niedertemperaturseite des ersten Wärmetauschers 2 aus Figur 1 durch die serielle Verschaltung der Wärmetauscher 2a bis 2d ersetzt ist.

Der Kühlkreislauf 21 verzweigt sich sowohl in seinem Vorlauf als auch in seinem Rücklauf in vier Zweige, wobei in dem Vorlauf 21 a die vier Zweige zu den Brennkraftmaschinen 12a bis 12d führen und im Rücklauf 21 b die vier Zweige von den Brennkraftmaschinen 12a bis 12d zu der Verzweigung zusammenführen und in den gemeinsamen Strang des Rücklaufs 21 b führen.

Die Funktion der in Figur 1 und Figur 2 dargestellten Anordnungen ist beispielsweise wie folgt:
Sobald die Brennkraftmaschine 12 oder 12a bis 12d gestartet worden ist, wird die zumindest eine Umwälzpumpe 7 eingeschaltet und es zirkuliert Wärmetransportfluid in dem ersten Wärmetransportkreislauf 22. Die heißen Abgase gelangen über den ersten Wärmetauscher 2 bzw. 2a bis 2d in den Wärmetransportkreislauf 22. Dementsprechend erzeugt der thermoelektrische Generator 1 elektrische Energie, die insbesondere für das Bordnetz des Fahrzeugs, z. B. eine Lokomotive mit angekoppelten Wagen, zur Verfügung steht. Die auf der Niedertemperaturseite des thermoelektrischen Generators 1 anfallende Abwärme wird vom Wärmetransportfluid des zweiten Wärmetransportkreislaufs 29, 30 abtransportiert und zumindest teilweise wie oben beschrieben über den Fluid-Luftwärmetauscher 4 an die Umgebung abgegeben.

Je nach Drehzahl oder auch je nach anderer Betriebsweise der Brennkraftmaschine 12 variiert die Temperatur des Abgases sowie der Abgas-Volumenstrom. Die thermische Leistung, mit der Wärme in den ersten Wärmetransportkreislauf 22 eingebracht wird, hängt somit von der Betriebsweise der zumindest einen Brennkraftmaschine ab. Durch eine Regelung oder Steuerung der zumindest einen Förderpumpe 7 in dem ersten Wärmetransportkreislauf 22 kann daher die Temperatur des Wärmetransportfluids an der Hochtemperaturseite des Generators 1 auf einen konstanten Wert oder innerhalb eines schmalen Temperaturbereichs gehalten werden. Dadurch wird eine optimale Konversion von Wärme in elektrische Energie durch den thermoelektrischen Generator 1 erreicht. Dies gilt insbesondere dann, wenn eine Lokomotive oder ein sonstiges Schienenfahrzeug fährt und daher immer wieder oder kontinuierlich Traktionsenergie von der zumindest einen Brennkraftmaschine geliefert wird.

Wenn das Fahrzeug abgebremst wird, kann zumindest ein elektrischer Traktionsmotor im generatorischen Betrieb elektrische Energie erzeugen und in das Bordnetz des Fahrzeugs und/oder direkt zur Aufladung des Latentwärmespeichers 3 bereitstellen. Insbesondere wenn der Latentwärmespeicher 3 Aluminium als Latentwärmespeichermedium enthält, kann der Speicherinhalt auf bis zu 750° C aufgeheizt werden. Beim Aufladen des Speichers beginnt Aluminium ab 660° C zu schmelzen. Wenn das gesamte Aluminium im Speicher verflüssigt worden ist, steigt die Temperatur auf die maximale Speichertemperatur an. Dann wird die Aufladung des Speichers gestoppt. Die Speichergröße bzw. die Speicherkapazität ist vorzugsweise so bemessen, dass in jeder Betriebsphase immer die beim Abbremsen des Fahrzeugs von der maximal zulässigen Geschwindigkeit bis zum Stillstand zur Verfügung stehende Bremsenergie im Latentwärmespeicher zur Aufladung genutzt werden kann.

Nach einer solchen Bremsung wird der Latentwärmespeicher vorzugsweise wieder so weit entladen, dass er für eine weitere Bremsung aus maximaler Fahrgeschwindigkeit zur Verfügung steht, d. h. wieder die entsprechende Bremsenergie aufnehmen kann. Durch die Entladung des Latentwärmespeichers wird von dem thermolektrischen Generator 1 Energie erzeugt, die insbesondere in das Bordnetz des Fahrzeugs eingespeist wird.

Die zuvor beschriebenen Funktionsweisen beschränken sich nicht auf den Betrieb in Figur 1 und Figur 2 dargestellten Anordnungen. Sie können vielmehr bei jeder anderen Ausgestaltung realisiert werden, in der ein Latentwärmespeicher zur Verfügung steht, der über einen thermoelektrischen Generator entladen werden kann.

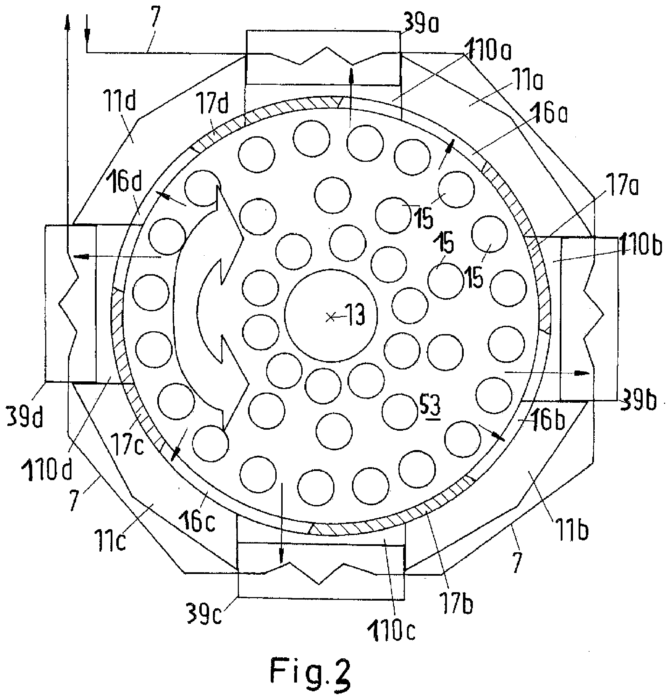

Vorzugsweise wird im Fall des Aluminium-Latentwärmespeichers die Entladung des Speichers beendet, wenn die Temperatur des Aluminiums unter 660° C fällt. Eine Möglichkeit zur Einstellung des Wärmeübergangs von dem Speichermedium des Latentwärmespeichers auf einen Wärmetransportkreislauf, insbesondere auf den Wärmetransportkreislauf 22 gemäß Figur 1 oder Figur 2, wird anhand von Figur 3 beschrieben.

Ein Latentwärmespeicher lässt sich thermisch sehr gut isolieren, so dass die Wärmeverluste bei längerer Unterbrechung des Betriebes des Fahrzeugs gering sind. Wird das Fahrzeug nach einer längeren Betriebsphase abgestellt, so ist der Latentwärmespeicher in der Regel voll oder nahezu voll aufgeladen, da zuletzt abgebremst wurde. Die gespeicherte Wärmeenergie kann noch nach mehreren Tagen zur Vorwärmung der Brennkraftmaschine genutzt werden. Daher kann in der Regel auf den Betrieb eines Vorwärmgerätes, das zusätzlich Kraftstoff verbraucht, verzichtet werden.

Insbesondere bei niedriger Fahrzeuggeschwindigkeit oder im Stillstand kann ein Fluid-Luftwärmetauscher (z. B. der Wärmetauscher 4), der Abwärme von dem thermoelektrischen Generator an die Umgebung abführen soll, nicht ausreichend Wärme an die Umgebung übertragen. In diesem Fall kann das Beipassventil 31 in Figur 1 oder Figur 2 geschlossen werden, wodurch das Wärmetransportfluid in dem zweiten Wärmetransportkreislauf 29, 30 durch die Hochtemperaturseite des dritten Wärmetauschers fließt und Wärme an den Kühlkreislauf 21 abgegeben wird.

Ein anderer Fall, in dem das Beipassventil 31 geschlossen oder nahezu geschlossen wird, ist der Fall der Vorwärmung der Brennkraftmaschine. In diesem Fall wird Wärme durch Entladung des Latentwärmespeichers aus diesem entnommen, der Hochtemperaturseite des thermoelektrischen Generators 1 zugeführt. In diesem Fall wird der thermoelektrische Generator jedoch nicht zur Erzeugung von elektrischer Energie genutzt, sondern wird die Wärme lediglich auf die Niedertemperaturseite übertragen, mittels des Wärmetransportfluids in dem zweiten Wärmetransportkreislaufs 29, 30 abgeführt und über die Hochtemperaturseite des dritten Wärmetauschers 5 auf den Kühlkreislauf 21 übertragen. Somit steht Wärme zur Vorwärmung der Brennkraftmaschine oder Brennkraftmaschinen zur Verfügung.

Unabhängig von den in Figur 1 und in Figur 2 dargestellten Ausführungsformen wird es daher bevorzugt, dass zur Vorwärmung der zumindest einen Brennkraftmaschine Wärme aus dem Latentwärmespeicher entnommen und über den thermoelektrischen Generator einem Kühlkreislauf der Brennkraftmaschine zugeführt wird, während in dieser Betriebsphase keine elektrische Energie von dem thermoelektrischen Generator abgeführt wird.

Daher wird es bevorzugt, dass der Kühlkreislauf entweder bereits allein aufgrund von Dichte-Unterschieden seines Wärmetransportfluids eine Zirkulation ermöglicht, oder dass eine Pumpe zur Zirkulation des Wärmetransportfluids unabhängig vom Betrieb der Brennkraftmaschine ist. Beispielsweise kann eine elektrisch angetriebene Pumpe eingesetzt werden.

Fig. 3 zeigt einen Querschnitt durch einen Latentwärmespeicher, wobei sich der Speicherbehälter in einer von mehreren möglichen Drehpositionen befindet, hier in einer Drehposition, in der eine Wärmeübergangsfläche eine mittlere Größe hat. Der Speicherbehälter 53 weist eine doppelwandige Außenwand auf, deren verschiedene Segmente mit den Bezugszeichen 16 und 17 bezeichnet sind. Dabei sind die Bereiche 16a, 16b, 16c, 16d mit einem gut wärmeleitenden Material, z.B. Graphit, gefüllt, dagegen sind die Bereiche 17a, 17b, 17c, 17d mit einem wärmeisolierenden Material versehen. Die Bereiche 16, 17 wechseln sich in Umfangsrichtung der Speicherbehälterwand alternierend ab. In dem Ausführungsbeispiel sind jeweils vier Bereiche mit gut wärmeleitendem Material und vier Bereiche mit wärmeisolierendem Material dargestellt. Es ist jedoch auch möglich, dass eine andere Anzahl von gut wärmeleitenden und isolierenden Bereichen der Behälterwand vorgesehen ist.

Entsprechend der Anzahl gut wärmeleitender und isolierender Bereiche der Behälterwand weist der Speicher eine gleichgroße Anzahl von ortsfesten Bereichen 110 auf, die ebenfalls durch gut wärmeleitendes Material, z.B. Graphit, gebildet sind. Radial außerhalb dieser Bereiche 10 befindet sich jeweils ein Blockwärmetauscher 39a, 39b, 39c, 39d, der insbesondere beim Betrieb des ersten Wärmetransportkreislaufs 22 aus Fig. 1 oder 2 von einem Fluid durchflossen wird, so dass das Fluid mit Wärme aus dem Speicherbehälter erwärmt wird. In Umfangsrichtung zwischen den Bereichen 110a, 110b, 110c, 110d aus gut wärmeleitendem Material befinden sich Bereiche aus wärmeisolierendem Material 11a, 11 b, 11 c, 11 d. Wie auch die verschiedenen Bereiche der Speicherbehälterwand wechseln sich diese gut wärmeleitenden Bereiche 110 und die wärmeisolierenden Bereiche 11 alternierend in Umfangsrichtung ab. Dabei erstrecken sich die gut wärmeleitenden Bereiche 16 der Speicherbehälterwand in Umfangsrichtung über denselben Winkelbereich wie die gut wärmeleitenden Bereiche 110. In einer möglichen, nicht dargestellten Drehstellung liegen diese gut wärmeleitenden Bereiche 16 der Speicherbehälterwand und die ortsfesten gut wärmeleitenden Bereiche 110 vollflächig aneinander. Daher liegen auch die wärmeisolierenden Bereiche 17 der Speicherbehälterwand und die ortsfesten isolierenden Bereiche 11 vollflächig aneinander an. Vorzugsweise sind die Winkelbereiche der gut wärmeleitenden Bereiche der Speicherwand und die Winkelbereiche der wärmeisolierenden Bereiche 17 der Speicherbehälterwand gleich groß. Der Grund hierfür liegt darin, dass in diesem Fall einerseits die größtmögliche Übertragungsfläche zur Übertragung von Wärme aus dem Speicherinneren auf die ortsfesten gut wärmeleitenden Bereiche 110 zur Verfügung steht und andererseits in einer anderen möglichen Drehstellung die maximal mögliche Wärmeisolierungswirkung erzielt wird.

Wie bereits erwähnt, ist der Speicherbehälter 53 um die Drehachse 13, die gleichzeitig seine Rotationssymmetrieachse ist, drehbar. Innerhalb des Speicherbehälters 53 befindet sich eine Mehrzahl von Heizwiderständen 15, die in Fig. 1 bis Fig. 3 durch Kreise symbolisiert sind. Zwischen den Heizwiderständen 15 befindet sich das Latentwärmespeichermaterial, im Ausführungsbeispiel Aluminium.

Beim Entladen des Speichers wird Wärme (wie durch insgesamt vier lange Pfeile angedeutet ist, die in radialer Richtung nach außen weisen) von dem Latentwärmespeichermedium durch die gut wärmeleitenden Bereiche 16 der Speicherbehälterwand und durch die gut wärmeleitenden, ortsfesten Bereiche 110 auf die Blockwärmetauscher 39 übertragen und damit auf das durch die Wärmetauscher 39 hindurchfließende Fluid. Der Fluidkreislauf ist schematisch dargestellt und mit dem Bezugszeichen 7 bezeichnet.

Im Inneren des Bereichs, der das eigentliche Latentwärmespeichermedium enthält, befindet sich eine mechanische Konstruktion, die die Drehbeweglichkeit des Speicherbehälters ermöglicht. Diese Konstruktion kann in unterschiedlicher Weise ausgeführt sein. Auf die Konstruktion wird hier nicht näher eingegangen.

In der in Fig. 3 dargestellten Drehstellung, die durch eine Drehung um 22,5° im Uhrzeigersinn aus der in Fig. 1 dargestellten Drehstellung erreicht wurde, liegt nur noch ein Teil der Außenoberfläche der gut wärmeleitenden Bereiche 16 der Speicherbehälterwand den gut wärmeleitenden Bereichen 110, die nicht mitgedreht werden, gegenüber. Daher kann nur noch über diesen Teil der Außenoberfläche der gut wärmeleitenden Bereiche 16 ein Wärmetransport von dem Latentwärmespeichermedium zu dem Kühlmittel in den Wärmetauscherblöcken 39 stattfinden. Im Ergebnis ist der Wärmeübergang reduziert.

## Patentansprüche

1. Anordnung zur Nutzung von Abwärme einer Brennkraftmaschine (12) in einem Fahrzeug, insbesondere in einem Schienenfahrzeug, wobei
- die Anordnung einen Abgasstrang (23) zum Ableiten von Abgasen der Brennkraftmaschine (12) aufweist,
- der Abgasstrang (23) thermisch mit einer Hochtemperaturseite eines thermoelektrischen Generators (1) gekoppelt ist,
- ein Latentwärmespeicher (3) thermisch mit der Hochtemperaturseite des thermoelektrischen Generators (1) gekoppelt ist.
**dadurch gekennzeichnet, dass** der Latentwärmespeicher (3) mit einer elektrischen Speicherladeeinrichtung kombiniert ist, die ausgestaltet ist, beim Abbremsen des Fahrzeugs erzeugte elektrische Energie zur Aufladung des Latentwärmespeichers (3) zu nutzen.

2. Anordnung nach Anspruch 1, wobei der thermoelektrische Generator (1) elektrisch mit einer Speicherladeeinrichtung (43) verbunden ist, die ausgestaltet ist, den Latentwärmespeicher (3) aufzuladen

3. Anordnung nach Anspruch 1 oder 2, wobei
- der Abgasstrang (23) über einen ersten Wärmetauscher (2) der Anordnung thermisch mit einem ersten Wärmetransportkreislauf (22) gekoppelt ist,
- ein Vorlauf (22a) des ersten Wärmetransportkreislaufs (22) von dem ersten Wärmetauscher (2) zu der Hochtemperaturseite des thermoelektrischen Generators (1) führt, um den Abgasstrang (23) mit der Hochtemperaturseite zu koppeln.

4. Anordnung nach Anspruch 3, wobei der Vorlauf (22a) über einen zweiten Wärmetauscher (39) zu der Hochtemperaturseite des thermoelektrischen Generators (1) führt und der zweite Wärmetauscher (39) den Vorlauf (22a) thermisch mit dem Latentwärmespeicher (3) koppelt.

5. Anordnung nach einem der Ansprüche 1 bis 4, wobei eine Steuereinrichtung der Anordnung ausgestaltet ist, eine Entladung des Latentwärmespeichers (3) über einen Wärmetauscher, insbesondere über den zweiten Wärmetauscher (39) nach dem vorhergehenden Anspruch, zu bewirken, sodass aus dem Latentwärmespeichers (3) entnommene Wärme der Hochtemperaturseite des thermoelektrischen Generators (1) zugeführt wird.

6. Anordnung nach einem der Ansprüche 1 bis 5, wobei eine Niedertemperaturseite des thermoelektrischen Generators (1) an einen zweiten Wärmetransportkreislauf (29-33) angekoppelt ist, über den während des Betriebes des thermoelektrischen Generators (1) Wärme zu einer Wärmesenke abtransportiert wird, und wobei der zweite Wärmetransportkreislauf (29-33) über einen dritten Wärmetauscher (5) thermisch mit einem Kühlmittelkreislauf (21) der Brennkraftmaschine (12) gekoppelt ist.

7. Verfahren zum Betreiben einer Brennkraftmaschine (12) in einem Fahrzeug, insbesondere in einem Schienenfahrzeug, wobei
- Abgase der Brennkraftmaschine (12) über einen Abgasstrang (23) abgeleitet werden,
- mit den Abgasen abgeleitete Abwärme der Brennkraftmaschine (12) einer Hochtemperaturseite eines thermoelektrischen Generators (1) zugeführt wird und der thermoelektrische Generator (1) unter Nutzung der Abwärme elektrische Energie erzeugt,
- außerdem Wärme aus einem Latentwärmespeicher (3) der Hochtemperaturseite des thermoelektrischen Generators (1) zugeführt wird und der thermoelektrische Generator (1) unter Nutzung der Wärme elektrische Energie erzeugt.
**dadurch gekennzeichnet, dass** beim Abbremsen des Fahrzeugs erzeugte elektrische Energie zur Aufladung des Latentwärmespeichers (3) genutzt wird.

8. Verfahren nach Anspruch 7, wobei von dem thermoelektrischen Generator (1) erzeugte elektrische Energie zumindest einem elektrischen Verbraucher des Fahrzeugs zugeführt wird.

9. Verfahren nach Anspruch 7 oder 8, wobei
- Abwärme der Brennkraftmaschine (12) von dem Abgasstrang (23) über einen ersten Wärmetauscher (2) in einen ersten Wärmetransportkreislauf (22) eingekoppelt wird,
- die Abwärme von dem ersten Wärmetransportkreislauf (22) zu der Hochtemperaturseite des thermoelektrischen Generators (1) transportiert wird.

10. Verfahren nach dem vorhergehenden Anspruch, wobei über den ersten Wärmetransportkreislauf (22) Wärme, die aus dem Latentwärmespeicher (3) entnommen wird, zu der Hochtemperaturseite des thermoelektrischen Generators (1) transportiert wird.

11. Verfahren nach einem der Ansprüche 7 bis 10, wobei zur Steuerung einer Entladung des Latentwärmespeichers (3) ein Behälter des Latentwärmespeichers (3) und ein Wärmetauscher (39), über den Wärme aus dem Latentwärmespeicher (3) entnehmbar ist, relativ zueinander bewegt werden, sodass sich der Wärmeübergang von einem Latentwärmespeichermedium des Latentwärmespeichers auf ein Wärmetransportmedium eines Wärmetransportkreislaufs, insbesondere des ersten Wärmetransportkreislaufs (22) gemäß Anspruch 11 oder 12, verändert.

12. Verfahren nach einem der Ansprüche 7 bis 11, wobei Wärme von einer Niedertemperaturseite des thermoelektrischen Generators (1) über einen zweiten Wärmetransportkreislauf (29-33) zu einer Wärmesenke abtransportiert wird und bei Bedarf zur Vorwärmung der Brennkraftmaschine (12) Wärme aus dem zweiten Wärmetransportkreislauf (29-33) in einen Kühlmittelkreislauf (21) der Brennkraftmaschine (12) eingekoppelt wird.

## Claims

1. An arrangement for utilising waste heat of an internal combustion engine (12) in a vehicle, in particular in a rail vehicle, wherein
- the arrangement comprises an exhaust gas tract (23) for removing exhaust gases of the internal combustion engine (12),
- the exhaust gas tract (23) is thermally coupled to a high-temperature side of a thermoelectric generator (1),
- a latent heat accumulator (3) is thermally coupled to the high-temperature side of the thermoelectric generator (1),
**characterised in that** the latent heat accumulator (3) is combined with an electrical accumulator-charging device, which is designed to use electrical energy generated under braking of the vehicle in order to charge the latent heat accumulator (3).

2. The arrangement according to claim 1, wherein the thermoelectric generator (1) is electrically connected to an accumulator-charging device (43), which is designed to charge the latent heat accumulator (3).

3. The arrangement according to claim 1 or 2, wherein
- the exhaust gas tract (23) is thermally coupled to a first heat transport circuit (22) via a first heat exchanger (2) of the arrangement,
- a feed line (22a) of the first heat transport circuit (22) leads from the first heat exchanger (2) to the high-temperature side of the thermoelectric generator (1) in order to couple the exhaust gas tract (23) to the high-temperature side.

4. The arrangement according to claim 3, wherein the feed line (22a) leads via a second heat exchanger (39) to the high-temperature side of the thermoelectric generator (1) and the second heat exchanger (39) thermally couples the feed line (22a) to the latent heat accumulator (3).

5. The arrangement according to any one of claims 1 to 4, wherein a control device of the arrangement is designed to bring about a discharge of the latent heat accumulator (3) via a heat exchanger, in particular via the second heat exchanger (39) according to the preceding claim, such that heat removed from the latent heat accumulator (3) is fed to the high-temperature side of the thermoelectric generator (1).

6. The arrangement according to any one of claims 1 to 5, wherein a low-temperature side of the thermoelectric generator (1) is coupled to a second heat transport circuit (29-33), via which heat is transported away to a heat sink during the operation of the thermoelectric generator (1), and wherein the second heat transport circuit (29-33) is thermally coupled via a third heat exchanger (5) to a coolant circuit (21) of the internal combustion engine (12).

7. A method for operating an internal combustion engine (12) in a vehicle, in particular in a rail vehicle, wherein
- exhaust gases of the internal combustion engine (12) are removed via an exhaust gas tract (23),
- waste heat of the internal combustion engine (12) removed with the exhaust gases is fed to a high-temperature side of a thermoelectric generator (1) and the thermoelectric generator (1) utilises the waste heat in order to generate electrical energy,
- in addition, heat from a latent heat accumulator (3) is fed to the high-temperature side of the thermoelectric generator (1) and the thermoelectric generator (1) utilises the heat in order to generate electrical energy,
**characterised in that** electrical energy generated under braking of the vehicle is used to charge the latent heat accumulator (3).

8. The method according to claim 7, wherein electrical energy generated by the thermoelectric generator (1) is fed to at least one electrical consumer of the vehicle.

9. The method according to claim 7 or 8, wherein
- waste heat of the internal combustion engine (12) is coupled from the exhaust gas tract (23) into a first heat transport circuit (22) via a first heat exchanger (2),
- the waste heat is transported from the first heat transport circuit (22) to the high-temperature side of the thermoelectric generator (1).

10. The method according to the preceding claim, wherein heat removed from the latent heat accumulator (3) is transported to the high-temperature side of the thermoelectric generator (1) via the first heat transport circuit (22).

11. The method according to any one of claims 7 to 10, wherein, in order to control a discharge of the latent heat accumulator (3), a container of the latent heat accumulator (3) and a heat exchanger (39), via which heat can be removed from the latent heat accumulator (3), are moved relative to one another, such that the heat transfer from a latent heat storage medium of the latent heat accumulator to a heat transport medium of a heat transport circuit, in particular of the first heat transport circuit (22) according to claim 11 or 12, changes.

12. The method according to any one of claims 7 to 11, wherein heat is transported away from a low-temperature side of the thermoelectric generator (1) to a heat sink via a second heat transport circuit (29-33), and, if there is a need, heat from the second heat transport circuit (29-33) is coupled into a coolant circuit (21) of the internal combustion engine (12) in order to pre-heat the internal combustion engine (12).

## Revendications

1. Ensemble servant à utiliser la chaleur perdue d'un moteur à combustion interne (12) dans un véhicule, en particulier dans un véhicule sur rails, dans lequel
- l'ensemble présente une ligne d'échappement (23) servant à évacuer des gaz d'échappement du moteur à combustion interne (12),
- la ligne d'échappement (23) est couplée thermiquement à un côté à température élevée d'un générateur thermoélectrique (1),
- un accumulateur de chaleur latente (3) est couplé thermiquement au côté à température élevée du générateur thermoélectrique (1),
**caractérisé en ce que** l'accumulateur à chaleur latente (3) est combiné à un dispositif de charge d'accumulateur électrique, qui est configuré pour utiliser, lors du ralentissement par freinage du véhicule, une énergie électrique produite aux fins de rechargement de l'accumulateur de chaleur latente (3).

2. Ensemble selon la revendication 1, dans lequel le générateur thermoélectrique (1) est relié de manière électrique au dispositif de charge d'accumulateur (43), qui est configuré pour recharger l'accumulateur de chaleur latente (3).

3. Ensemble selon la revendication 1 ou 2, dans lequel
- la ligne d'échappement (23) est couplée thermiquement au premier circuit de transport de chaleur (22) par l'intermédiaire d'un premier échangeur de chaleur (2) de l'ensemble,
- une arrivée (22a) du premier circuit de transport de chaleur (22) mène depuis le premier échangeur de chaleur (2) au côté à température élevée du générateur thermoélectrique (1) afin de coupler la ligne d'échappement (23) au côté à température élevée.

4. Ensemble selon la revendication 3, dans lequel l'arrivée (22a) mène, par l'intermédiaire d'un deuxième échangeur de chaleur (39), au côté à température élevée du générateur thermoélectrique (1) et le deuxième échangeur de chaleur (39) couple l'arrivée (22a) thermiquement à l'accumulateur de chaleur latente (3).

5. Ensemble selon l'une quelconque des revendications 1 à 4, dans lequel un dispositif de commande de l'ensemble est configuré pour entraîner un déchargement de l'accumulateur de chaleur latente (3) par l'intermédiaire d'un échangeur de chaleur, en particulier par l'intermédiaire du deuxième échangeur de chaleur (39) selon la revendication précédente, de sorte que la chaleur prélevée de l'accumulateur de chaleur latente (3) est amenée au côté à température élevée du générateur thermoélectrique (1).

6. Ensemble selon l'une quelconque des revendications 1 à 5, dans lequel le côté à basse température du générateur thermoélectrique (1) est accouplé à un deuxième circuit de transport de chaleur (29 - 33), par l'intermédiaire duquel de la chaleur est évacuée, au cours du fonctionnement du générateur thermoélectrique (1), en direction d'un dissipateur thermique, et dans lequel le deuxième circuit de transport de chaleur (29 - 33) est couplé thermiquement à un circuit de liquide de refroidissement (21) du moteur à combustion interne (12) par l'intermédiaire d'un troisième échangeur de chaleur (5).

7. Procédé servant à faire fonctionner un moteur à combustion interne (12) dans un véhicule, en particulier dans un véhicule sur rails, dans lequel
- des gaz d'échappement du moteur à combustion interne (12) sont évacués par l'intermédiaire d'une ligne d'échappement (23),
- la chaleur perdue dérivant des gaz d'échappement du moteur à combustion interne (12) est amenée à un côté à température élevée d'un générateur thermoélectrique (1) et le générateur thermoélectrique (1) produit de l'énergie électrique en utilisant la chaleur perdue,
- par ailleurs de la chaleur provenant de l'accumulateur de chaleur latente (3) est amenée au côté à température élevée du générateur thermoélectrique (1) et que le générateur thermoélectrique (1) produit de l'énergie électrique en utilisant la chaleur,
**caractérisé en ce que** l'énergie électrique produite lors du ralentissement par freinage du véhicule est utilisée pour recharger l'accumulateur de chaleur latente (3).

8. Procédé selon la revendication 7, dans lequel l'énergie électrique produite par le générateur thermoélectrique (1) est amenée au moins à un consommateur électrique du véhicule.

9. Procédé selon la revendication 7 ou 8, dans lequel
- la chaleur perdue du moteur à combustion interne (12) est injectée par la ligne d'échappement (23) dans un premier circuit de transport de chaleur (22) par l'intermédiaire d'un premier échangeur de chaleur (2),
- la chaleur perdue est transportée par le premier circuit de transport de chaleur (22) en direction du côté à température élevée du générateur thermoélectrique (1).

10. Procédé selon la revendication précédente, dans lequel de la chaleur, qui est prélevée de l'accumulateur de chaleur latente (3), est transportée par l'intermédiaire du premier circuit de transport de chaleur (22), en direction du côté à température élevée du générateur thermoélectrique (1).

11. Procédé selon l'une quelconque des revendications 7 à 10, dans lequel aux fins de la commande d'un déchargement de l'accumulateur de chaleur latente (3), un contenant de l'accumulateur de chaleur latente (3) et un échangeur de chaleur (39), par l'intermédiaire duquel la chaleur peut être prélevée de l'accumulateur de chaleur latente (3), sont déplacés l'un par rapport à l'autre de telle sorte que le transfert de chaleur d'un milieu d'accumulateur de chaleur latente de l'accumulateur de chaleur latente sur un milieu de transport de chaleur d'un circuit de transport de chaleur, en particulier du premier circuit de transport de chaleur (22) selon la revendication 11 ou 12, varie.

12. Procédé selon l'une quelconque des revendications 7 à 11, dans lequel la chaleur est évacuée par transport depuis un côté à basse température du générateur thermoélectrique (1), en passant par un deuxième circuit de transport de chaleur (29 - 33), en direction d'un dissipateur thermique et qu'au besoin, aux fins du préchauffage du moteur à combustion interne (12), de la chaleur provenant du deuxième circuit de transport de chaleur (29 - 33) est injectée dans un circuit de liquide de refroidissement (21) du moteur à combustion interne (12).
